(19) **Europäisches Patentamt**
**European Patent Office**
**Office européen des brevets**

(11) **EP 2 871 792 A1**

(12) **EUROPEAN PATENT APPLICATION**
published in accordance with Art. 153(4) EPC

(43) Date of publication:
**13.05.2015 Bulletin 2015/20**

(51) Int Cl.:
***H04L 1/00*** *(2006.01)*

(21) Application number: **12880951.4**

(86) International application number:
**PCT/CN2012/078383**

(22) Date of filing: **09.07.2012**

(87) International publication number:
**WO 2014/008624 (16.01.2014 Gazette 2014/03)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **ZTE Corporation**
**Shenzhen, Guangdong 518057 (CN)**

(72) Inventors:
• **FU, Huajie**
**Shenzhen**
**Guangdong 518057 (CN)**
• **ZHANG, Xiaopeng**
**Shenzhen**
**Guangdong 518057 (CN)**

(74) Representative: **Tischner, Oliver**
**Lavoix Munich**
**Bayerstrasse 83**
**80335 München (DE)**

(54) **DATA STORAGE METHOD AND DEVICE**

(57) A data storage method is provided, which includes setting a storage structure of a storage module, and after data are received, storing the received data into the storage module according to a parallel storage mode. Accordingly a data storage device is provided. Since data storage here is performed mainly by shift operations and modular operations, less resources are used and overheads are relatively small; moreover, since data storage is performed in a parallel mode, the storage delay is relatively short; furthermore, inputs lines are only needed to be connected with part of storages, thus wiring is simple and has a relatively low cost.

Fig. 3

301

A storage structure of a storage module is set

302

After data are received, the received data are stored into the storage module according to a parallel storage mode

EP 2 871 792 A1

**Description**

**TECHNICAL FIELD**

The disclosure relates to the field of data storage, and in particular to a data storage method and device.

**BACKGROUND**

Channel encoding/decoding techniques are usually used in communication standards to reduce error rates during data transmission. Low Density Parity Check (LDPC) codes were proposed by Gallager in 1962, which are linear block codes defined by sparse check matrices, involve a simple iteration decoding algorithm and have performances approaching the Shannon limit. Since the re-discovery of LDPC codes by MacKay and Neal in 1995, theoretical researches on LDPC codes and related practical applications have a great progress. At present, LDPC codes are used in a great number of standards of communication systems, such as DVB-S2, WiMAX, IEEE 802.3an and DMB-TH.

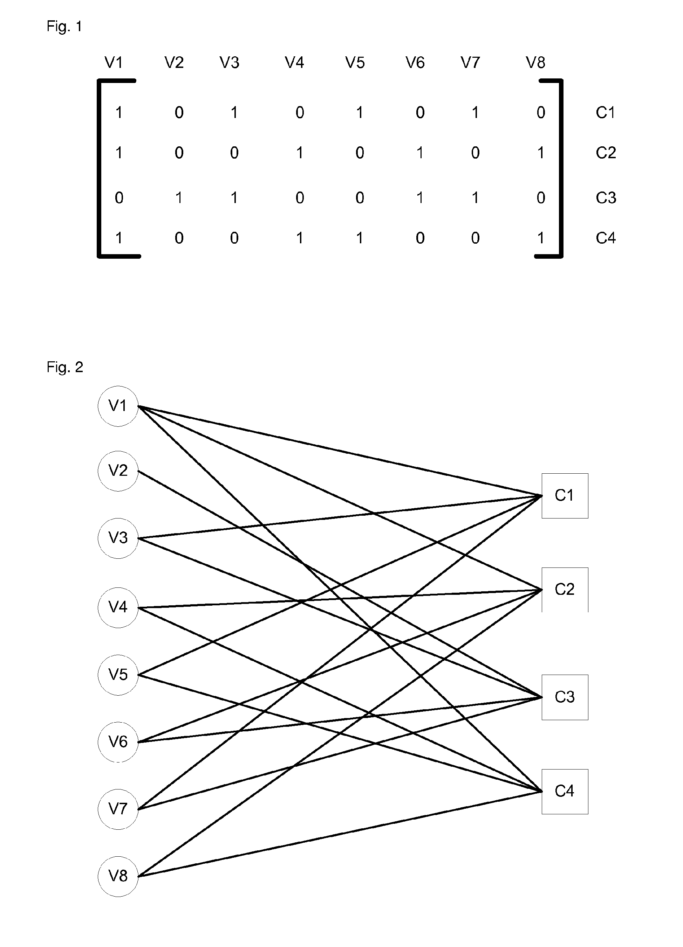

The Parity check matrix of LDPC codes is a sparse matrix that can be intuitively represented by a Tanner graph. All LDPC codes include variable nodes and check nodes. According to a connection relation between variable nodes and check nodes in a Tanner graph, LDPC codes can be categorized into structured LDPC codes and non-structured LDPC codes, wherein structured LDPC codes are widely applied in real products due to advantages such as low complexity and being easy to be implemented by hardwares. To balance throughout and overheads of hardware resources, a device for decoding structured LDPC codes typically employs a partially parallel decoding method, i.e., performing simultaneous or non-simultaneous updating on a certain number of check nodes or variable nodes every time. In related techniques, a check matrix of LDPC codes is as shown in Fig. 1, and a corresponding Tanner graph is as shown in Fig. 2, wherein a variable node is represented by Vi (i=1-8) and a check node is represented by Cj (j=1-4).

A device for decoding LDPC codes generally includes a storage part, a processing part, and a control and output part. One of key techniques for implementing a decoding device is storage of decoded codes, particularly for LDPC codes having a relatively long code length, storage of a check matrix and storage of intermediate results during iteration may result in relatively huge overheads of resources and area, generally occupying above 50% of the whole area of the decoding device. In addition, one communication standard generally provides multiple code rates and code lengths to meet demands of different application scenarios. Theoretically, to implement a decoding device supporting multiple code rates, check matrices at multiple code rates need to be stored, and since check nodes at different code rates have different degrees, irregularity of storage of intermediate results will be resulted during a decoding process, and accordingly increases overheads of area of the decoding device.

In general, in related techniques, storage of related data in a device for decoding LDPC codes is done mainly by add operations, which thus occupies too many resources and has relatively large overheads; moreover, since data are stored in a serial mode in related techniques, a relatively long storage delay is caused; furthermore, in related techniques, input lines need to be connected with each storage, thus the wiring is complicated and costly.

**SUMMARY**

In view of the above, embodiments of the disclosure provide a data storage method and device capable of saving resources, decreasing overheads, reducing a storage delay, lowering wiring complexity and saving cost.

To this end, the technical solutions of the disclosure are implemented as follows.

A data storage method, including:

setting a storage structure of a storage module;

receiving data, and storing the received data into the storage module according to a parallel storage mode.

The storage module may consist of multiple RAMs.

The setting a storage structure of a storage module may include setting NR which represents the number of RAMs, RR which represents the number of rows in each RAM and RL which represents the number of columns RL in each RAM.

The setting a storage structure of a storage module may include:

setting NR=BL*Max_NI, wherein BL is a number of columns of a base matrix, Max_NI is the maximum number of data input; and

setting RR=Z/P, RL=Z/RR, wherein Z is an expansion factor, P is a data storage parallelism.

The storing the data received into the storage module according to a parallel storage mode may include:

determining a row address Ri and a column address Li of the data in the storage module are determined;

storing the data into the storage module according to the determined row address Ri and the determined column address Li,

wherein the determining a row address Ri and a column address Li of the data in the storage module may include:

determining Ri= i mod (Z/P), and

determining Li= (I div Z) + {[(i mod 4)*(16/P)+(i mod Z)div(Z/P)]mod(64/P)},

wherein mod represents a modular arithmetic, div represents an integer division arithmetic, i is a sequence number of data input, Z is an expansion factor and P is a data storage parallelism.

P may be set as a value 4.
A data storage device including a storage module, a reception module and a storage execution module, wherein the storage module is configured to store data;
the reception module is configured to receive data; and
the storage execution module is configured to store the data received by the reception module into the storage module according to a parallel storage mode.
The storage module may consist of multiple RAMs.
The storage execution module may be specifically configured to determine a row address Ri and a column address Li of the data in the storage module and store the data into the storage module according to the determined row address Ri and the determined column address Li, wherein Ri= i mod (Z/P), Li= (i div Z) + {[(i mod 4)*(16/P)+(i mod Z)div(Z/P)]mod(64/P)}, mod represents a modular arithmetic, div represents an integer division arithmetic, i is a sequence number of data input, Z is an expansion factor and P is a data storage parallelism.
In the data storage method and device provided by embodiments of the disclosure, a storage structure of a storage module is set; after data are received, the received data are stored into the storage module according to a parallel storage mode. In solutions according to embodiments of the disclosure, since data storage is performed mainly by shift operations and modular operations, less resources are used and overheads are relatively small; moreover, since data storage is performed in a parallel mode, the storage delay is relatively short; furthermore, inputs lines are only needed to be connected with part of storages, thus wiring is simple and has a relatively low cost.

**BRIEF DESCRIPTION OF THE DRAWINGS**

Fig. 1 is a schematic diagram of a parity check matrix of LDPC codes according to related techniques;

Fig. 2 is a Tanner graph corresponding to the parity check matrix of Fig. 1;

Fig. 3 is a schematic flow chart of a data storage method according to an embodiment of the disclosure;

Fig, 4 is a schematic diagram of a storage structure according to an embodiment of the disclosure; and

Fig, 5 is a schematic diagram of a storage structure according to related techniques.

**DETAILED DESCRIPTION**

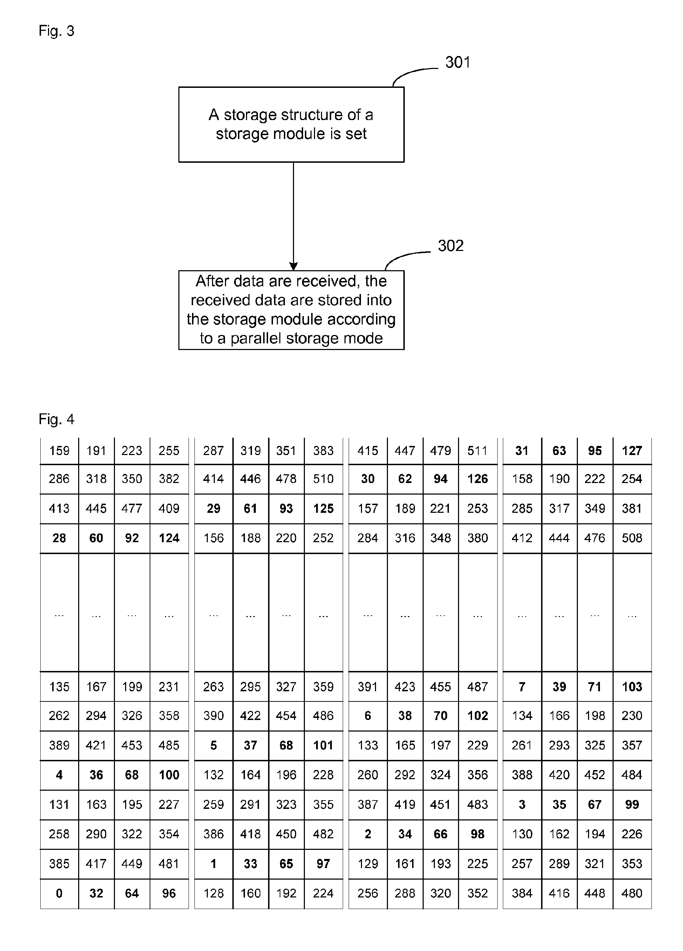

Embodiments of the disclosure provide a data storage method, Fig. 3 is a schematic flow chart of a data storage method according to an embodiment of the disclosure, as shown in Fig. 3, the method includes:

Step 301, a storage structure of a storage module is set;

optionally, the storage module may consist of multiple Random Access Memories (RAMs), and the multiple RAMs generally have a same size.

The operation of this step can be accomplished manually by an individual.

Optionally, the setting a storage structure of a storage module may include setting NR which is the number of RAMs, RR which is the number of rows in each RAM and RL which is the number of columns in each RAM.

Optionally, the setting a storage structure of a storage module may include:

setting NR=BL*Max_NI, wherein BL is the number of columns of a base matrix, Max_NI is the maximum number of data inputted; and

setting RR=Z/P, RL=Z/RR, wherein Z is an expansion factor, P is a data storage parallelism.

For an embodiment in which the number of rows of a base matrix is 4, the number of columns of the base matrix is 32, a expansion factor is 512 and a data storage parallelism is 16, a storage structure of an RAM is provided as shown in Fig. 4; it can be seen that Z=512 and P=16, thus the RAM has RR=512/16=32 rows and RL=512/32=16 columns; Fig. 4 only illustrates the storage structure of one RAM group, other 31 groups of RAMs have the same storage structure as the current one, that is, after data are fully stored in one RAM group, remaining data will be stored sequentially in a next RAM group.

Step 302, after data are received, the received data are stored into the storage module according to a parallel storage mode.

Optionally, in this step storing the received data into the storage module according to a parallel storage mode may include:

determining a row address Ri and a column address Li of the data in the storage module;

storing the data into the storage module according to the determined row address Ri and the determined column address Li.

Optionally, the determining a row address Ri and a column address Li of the data in the storage module may include:

$$\text{determining } Ri = i \bmod (Z/P),$$

and

$$\text{determining } Li = (i \text{ div } Z) + \{[(i \bmod 4)*(16/P) + (i \bmod Z)\text{div}(Z/P)]\bmod(64/P)\},$$

wherein mod represents a modular arithmetic, div represents an integer division arithmetic, i is a sequence number of data input, Z is a expansion factor and P is a data storage parallelism.

Preferably, P may have a value of 4.

Referring to Fig. 4, numbers in Fig. 4 represent sequence numbers of data input, the input data are input in parallel into the RAM according to their respective sequence numbers; assuming that the data are input in a 4-way parallel mode and input data has a sequence number i, then according to the storage method of the disclosure, a row address and a column address where the data is located are as follows:

$$\text{Row address } Ri = i \bmod 32$$

$$\text{Column address } Li = (i \text{ div} 512) + \{[(i \bmod 4)*4 + (i \bmod 512)\text{div} 32]\bmod 16\}$$

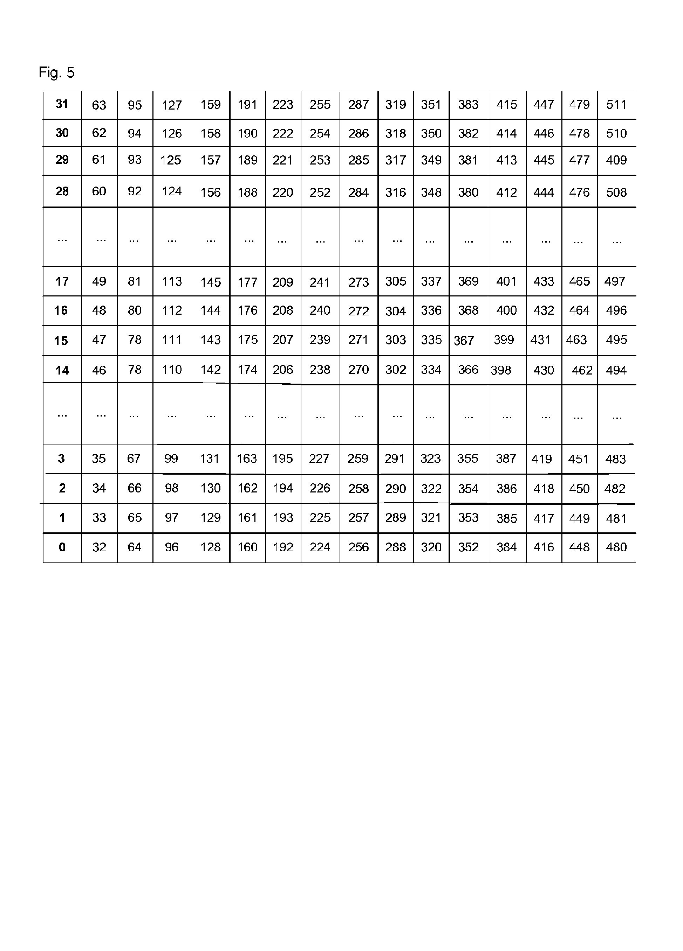

It can be seen that compared to an LDPC decoding RAM storage structure according to related techniques in Fig. 5, through which it takes n clock cycles to store n data, the embodiment as shown in Fig. 4 only takes n/4 clock cycle, thus reducing storage delay without an increase in overheads.

An embodiment of the disclosure provides accordingly a data storage device, and the device includes a storage module, a reception module and a storage execution module, wherein

the storage module is configured to store data;

the reception module is configured to receive data; and

the storage execution module is configured to store data received by the reception module into the storage module according to a parallel storage mode.

Optionally, the storage module may include multiple RAMs.

Optionally, the storage execution module may be specifically configured to determine a row address Ri and a column address Li of the data in the storage module and store the data into the storage module according to the determined row address Ri and the determined column address Li, wherein $Ri = i \bmod (Z/P)$, $Li = (i \operatorname{div} Z) + \{[(i \bmod 4)*(16/P)+(i \bmod Z)\operatorname{div}(Z/P)]\bmod(64/P)\}$, mod represents a modular arithmetic, div represents an integer division arithmetic, i is a sequence number of data input, Z is an expansion factor and P is a data storage parallelism.

In addition, it should be noted that an LDPC decoding storage device mainly has three functions: storing input data into the decoding storage device, reading a variable node desired to be decoded from the decoding storage device during a data decoding process, and writing information of an updated variable node into the decoding storage device during the data decoding process, wherein variable updating includes reading last-iterated variable nodes and writing currently-iterated variable nodes. Since the access technique takes variable node updating into account when data are input, when a variable node is updated it is only necessary to calculate a row address of a firstly-read variable node in the RAM, row addresses of subsequently-read variable nodes in the RAM then can be gotten through incrementing the address successively with +1 and performing a modular arithmetic on the incremented address values. The row address of the firstly-read variable node in the RAM is a value obtained by performing a modular arithmetic on a sequence number of a first valid data in a currently-processed code block and a maximum row address of the RAM.

The writing of a variable node has a same logic as the reading of the variable node in terms of address control. There is an information processing time delay between a read variable node and an updated variable node, and the reading of a variable node has a same control logic as the writing of the variable node, thus in practical implementations the reading and writing operations can be performed simultaneously on a storage without worrying about reading/writing collision. In this way, storage efficiency is greatly improved.

To sum up, technical solutions according to embodiments of the disclosure have the following beneficial effects:

1. a relatively small overheads, that is, avoiding overheads consumed due to the adoption of a "space for time" strategy for the purpose of increasing the rate of inputting data;

2. a relatively high utilization of the storage (i.e., the storage module) and power-saving, that is, since unnecessary space overheads is reduced, the utilization of the storage is consequently improved, and meanwhile control logics are simplified and thus the consumed power is saved;

3. a great input data throughout, thus increasing the throughout of the whole LDPC decoding;

4. avoidance of complicated arithmetic operations during the implementation of data storage and thus easy to be implemented by hardware: most of storage control logics used in the disclosure are used to perform modular operations, which exhibit left/right shifting of bits in hardware implementation and are relatively easy to be implemented; and

5. a decrease in complexity of subsequent layout and wiring: since data are frequently exchanged in LDPC decoding, wiring resources are fairly complicated, however, the method in the disclosure can make the wiring resources reduced, thus improving logic time sequence and lessening the pressure of subsequent layout and wiring.

What described are merely embodiments of the disclosure, and are not intended to limit the disclosure.

## Claims

1. A data storage method, **characterized in that** the method comprises:

    setting a storage structure of a storage module;
    receiving data, and then storing the data received into the storage module according to a parallel storage mode.

2. The data storage method according to claim 1, **characterized in that** the storage module consists of a plurality of Random Access Memories (RAMs);

the setting a storage structure of a storage module comprises setting NR which represents the number of RAMs, RR which represents the number of rows in each RAM and RL which represents the number of columns in each RAM.

3. The data storage method according to claim 2, **characterized in that** the setting a storage structure of a storage module comprises:

setting NR=BL*Max_NI, wherein BL is the number of columns of a base matrix, Max_NI is a maximum number of data input; and
setting RR=Z/P, RL=Z/RR, wherein Z is an expansion factor, P is a data storage parallelism.

4. The data storage method according to any one of claims 1 to 3, **characterized in that** the storing the data received into the storage module according to a parallel storage mode comprises:

determining a row address Ri and a column address Li of the data in the storage module;
storing the data into the storage module according to the determined row address Ri and the determined column address Li;
wherein the determining a row address Ri and a column address Li of the data in the storage module comprises:

determining $Ri = i \bmod (Z/P)$, and

and

determining $Li = (i \operatorname{div} Z) + \{[(i \bmod 4)*(16/P)+(i \bmod Z)\operatorname{div}(Z/P)]\bmod(64/P)\}$,

wherein mod represents a modular arithmetic, div represents an integer division arithmetic, i is a sequence number of data input, Z is an expansion factor and P is a data storage parallelism.

5. The data storage method according to claim 4, **characterized in that** P is set as a value 4.

6. A data storage device comprising a storage module, a reception module and a storage execution module, wherein
the storage module is configured to store data;
the reception module is configured to receive data; and
the storage execution module is configured to store the data received by the reception module into the storage module according to a parallel storage mode.

7. The data storage device according to claim 6, **characterized in that** the storage module consists of a plurality of Random Access Memories (RAMs).

8. The data storage device according to claim 6 or 7, **characterized in that**,
the storage execution module is specifically configured to determine a row address Ri and a column address Li of the data in the storage module and store the data into the storage module according to the determined row address Ri and the determined column address Li, wherein $Ri = i \bmod (Z/P)$, $Li = (i \operatorname{div} Z) + \{[(i \bmod 4)*(16/P)+(i \bmod Z)\operatorname{div}(Z/P)]\bmod(64/P)\}$, mod represents a modular arithmetic, div represents an integer division arithmetic, i is a sequence number of data input, Z is an expansion factor and P is a data storage parallelism.

Fig. 1

|  | V1 | V2 | V3 | V4 | V5 | V6 | V7 | V8 |  |
|---|---|---|---|---|---|---|---|---|---|
|  | 1 | 0 | 1 | 0 | 1 | 0 | 1 | 0 | C1 |
|  | 1 | 0 | 0 | 1 | 0 | 1 | 0 | 1 | C2 |
|  | 0 | 1 | 1 | 0 | 0 | 1 | 1 | 0 | C3 |
|  | 1 | 0 | 0 | 1 | 1 | 0 | 0 | 1 | C4 |

Fig. 2

Fig. 3

301

A storage structure of a storage module is set

302

After data are received, the received data are stored into the storage module according to a parallel storage mode

Fig. 4

| 159 | 191 | 223 | 255 | 287 | 319 | 351 | 383 | 415 | 447 | 479 | 511 | 31 | 63 | 95 | 127 |
|---|---|---|---|---|---|---|---|---|---|---|---|---|---|---|---|
| 286 | 318 | 350 | 382 | 414 | 446 | 478 | 510 | 30 | 62 | 94 | 126 | 158 | 190 | 222 | 254 |
| 413 | 445 | 477 | 409 | 29 | 61 | 93 | 125 | 157 | 189 | 221 | 253 | 285 | 317 | 349 | 381 |
| 28 | 60 | 92 | 124 | 156 | 188 | 220 | 252 | 284 | 316 | 348 | 380 | 412 | 444 | 476 | 508 |
| ... | ... | ... | ... | ... | ... | ... | ... | ... | ... | ... | ... | ... | ... | ... | ... |
| 135 | 167 | 199 | 231 | 263 | 295 | 327 | 359 | 391 | 423 | 455 | 487 | 7 | 39 | 71 | 103 |
| 262 | 294 | 326 | 358 | 390 | 422 | 454 | 486 | 6 | 38 | 70 | 102 | 134 | 166 | 198 | 230 |
| 389 | 421 | 453 | 485 | 5 | 37 | 68 | 101 | 133 | 165 | 197 | 229 | 261 | 293 | 325 | 357 |
| 4 | 36 | 68 | 100 | 132 | 164 | 196 | 228 | 260 | 292 | 324 | 356 | 388 | 420 | 452 | 484 |
| 131 | 163 | 195 | 227 | 259 | 291 | 323 | 355 | 387 | 419 | 451 | 483 | 3 | 35 | 67 | 99 |
| 258 | 290 | 322 | 354 | 386 | 418 | 450 | 482 | 2 | 34 | 66 | 98 | 130 | 162 | 194 | 226 |
| 385 | 417 | 449 | 481 | 1 | 33 | 65 | 97 | 129 | 161 | 193 | 225 | 257 | 289 | 321 | 353 |
| 0 | 32 | 64 | 96 | 128 | 160 | 192 | 224 | 256 | 288 | 320 | 352 | 384 | 416 | 448 | 480 |

Fig. 5

| 31 | 63 | 95 | 127 | 159 | 191 | 223 | 255 | 287 | 319 | 351 | 383 | 415 | 447 | 479 | 511 |
|---|---|---|---|---|---|---|---|---|---|---|---|---|---|---|---|
| 30 | 62 | 94 | 126 | 158 | 190 | 222 | 254 | 286 | 318 | 350 | 382 | 414 | 446 | 478 | 510 |
| 29 | 61 | 93 | 125 | 157 | 189 | 221 | 253 | 285 | 317 | 349 | 381 | 413 | 445 | 477 | 409 |
| 28 | 60 | 92 | 124 | 156 | 188 | 220 | 252 | 284 | 316 | 348 | 380 | 412 | 444 | 476 | 508 |
| ... | ... | ... | ... | ... | ... | ... | ... | ... | ... | ... | ... | ... | ... | ... | ... |
| 17 | 49 | 81 | 113 | 145 | 177 | 209 | 241 | 273 | 305 | 337 | 369 | 401 | 433 | 465 | 497 |
| 16 | 48 | 80 | 112 | 144 | 176 | 208 | 240 | 272 | 304 | 336 | 368 | 400 | 432 | 464 | 496 |
| 15 | 47 | 78 | 111 | 143 | 175 | 207 | 239 | 271 | 303 | 335 | 367 | 399 | 431 | 463 | 495 |
| 14 | 46 | 78 | 110 | 142 | 174 | 206 | 238 | 270 | 302 | 334 | 366 | 398 | 430 | 462 | 494 |
| ... | ... | ... | ... | ... | ... | ... | ... | ... | ... | ... | ... | ... | ... | ... | ... |
| 3 | 35 | 67 | 99 | 131 | 163 | 195 | 227 | 259 | 291 | 323 | 355 | 387 | 419 | 451 | 483 |
| 2 | 34 | 66 | 98 | 130 | 162 | 194 | 226 | 258 | 290 | 322 | 354 | 386 | 418 | 450 | 482 |
| 1 | 33 | 65 | 97 | 129 | 161 | 193 | 225 | 257 | 289 | 321 | 353 | 385 | 417 | 449 | 481 |
| 0 | 32 | 64 | 96 | 128 | 160 | 192 | 224 | 256 | 288 | 320 | 352 | 384 | 416 | 448 | 480 |

<table>
<tr><td colspan="2"><strong>INTERNATIONAL SEARCH REPORT</strong></td><td>International application No.<br><br><strong>PCT/CN2012/078383</strong></td></tr>
</table>

**A. CLASSIFICATION OF SUBJECT MATTER**

H04L 1/00 (2006.01) i
According to International Patent Classification (IPC) or to both national classification and IPC

**B. FIELDS SEARCHED**

Minimum documentation searched (classification system followed by classification symbols)

IPC: H04L

Documentation searched other than minimum documentation to the extent that such documents are included in the fields searched

Electronic data base consulted during the international search (name of data base and, where practicable, search terms used)

WPI; EPODOC; CNKI; CNPAT: block number, row number, line number, decode, low density parity check, decoder; block, memory, parallel, architecture, row, line, read, write, LDPC, coder

**C. DOCUMENTS CONSIDERED TO BE RELEVANT**

| Category* | Citation of document, with indication, where appropriate, of the relevant passages | Relevant to claim No. |
|---|---|---|
| X | CN 101335592 A (BEIJING INSTITUTE OF TECHNOLOGY), 31 December 2008 (31.12.2008), description, pages 1-8 | 1, 6-7 |
| Y | | 2 |
| Y | CN 102064835 A (INSTITUTE OF MICROELECTRONICS, CHINESE ACADEMY OF SCIENCES), 18 May 2011 (18.05.2011), description, paragraphs 0012-0013 | 2 |
| A | CN 102347775 A (FUDAN UNIVERSITY), 08 February 2012 (08.02.2012), the whole document | 1-8 |
| A | US 2002/0184447 A1 (MOELLER, H.), 05 December 2002 (05.12.2002), the whole document | 1-8 |

☐ Further documents are listed in the continuation of Box C. ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 13 March 2013 (13.03.2013) | **11 April 2013 (11.04.2013)** |

| Name and mailing address of the ISA/CN:<br>State Intellectual Property Office of the P. R. China<br>No. 6, Xitucheng Road, Jimenqiao<br>Haidian District, Beijing 100088, China<br>Facsimile No.: (86-10) 62019451 | Authorized officer<br><br>**WANG, Jing**<br><br>Telephone No.: (86-10) **62413627** |
|---|---|

Form PCT/ISA/210 (second sheet) (July 2009)

**INTERNATIONAL SEARCH REPORT**
Information on patent family members

| International application No. |
| --- |
| **PCT/CN2012/078383** |

| Patent Documents referred in the Report | Publication Date | Patent Family | Publication Date |
| --- | --- | --- | --- |
| CN 101335592 A | 31.12.2008 | None | |
| CN 102064835 A | 18.05.2011 | None | |
| CN 102347775 A | 08.02.2012 | None | |
| US 2002/0184447 A1 | 05.12.2002 | WO 0145109 A2 | 21.06.2001 |
| | | DE 19961138 A1 | 02.08.2001 |
| | | CN 1411577 A | 16.04.2003 |

Form PCT/ISA/210 (patent family annex) (July 2009)